# EUROPEAN PATENT APPLICATION

(11) **EP 4 462 481 A1**
(43) Date of publication of application: **13.11.2024**
(21) Application number: 24158952.2
(22) Date of filing: 21.02.2024
(51) Int. Cl.: H01L 25/075, H01L 25/16, H01L 33/62, H01L 33/00, H01L 33/48, H01L 33/56, H01L 33/60

(54) **LIGHT-EMITTING ELEMENT PACKAGE, DISPLAY DEVICE USING THE SAME, AND METHOD FOR MANUFACTURING SAID DISPLAY DEVICE**

(30) Priority: 11.05.2023 KR 20230061145
(71) Applicant: LG Electronics Inc., Yeongdeungpo-gu Seoul 07336 (KR)
(72) Inventor: CHOI, Hwanjoon, 06772 Seoul (KR); LEE, Yonghan, 06772 Seoul (KR); RHEE, Byungjoon, 06772 Seoul (KR)
(74) Representative: Vossius & Partner Patentanwälte Rechtsanwälte mbB

(57) **Abstract**

The present disclosure is applicable to the field of display devices, for example to a display device using a micro light-emitting diode. The disclosed light-emitting element package (200) includes: a first layer (210) including a terminal (211; 212), a second layer (220) located adjacent to the first layer and including a driving chip (250), a third layer (230) located adjacent to the second layer, wherein the third layer includes light-emitting elements (260), wherein each light-emitting element at least partially overlaps the driving chip in a connection direction of the first layer and the second layer and constitutes a unit subpixel, and a fourth layer (240) located adjacent to the third layer, wherein light emitted from the light-emitting elements passes through the fourth layer. A first electrode (262) of each of the light-emitting elements is connected to a first end (251) of the driving chip, and a second end (252) of the driving chip is connected to the terminal.

## Description

This application claims the benefit of Korean Patent Application No. 10-2023-0061145, filed on May 11, 2023, which is hereby incorporated by reference as if fully set forth herein.

### BACKGROUND

### Field

The present disclosure is applicable to a technical field related to a display device and, for example, relates to a display device using a micro light emitting diode (LED).

### Discussion of the Related Art

Recently, in a field of a display technology, display devices having excellent characteristics such as thinness, flexibility, and the like have been developed. On the other hand, currently commercialized major displays are represented by a LCD (liquid crystal display) and an OLED (organic light emitting diode).

On the other hand, LED (light emitting diode), which is a well-known semiconductor light-emitting element that converts electric current into light, has been used as a light source for a display image of an electronic device including an information and communication device along with a GaP:N-based green LED, starting with commercialization of a red LED using a GaAsP compound semiconductor in 1962. Accordingly, a method for solving the above-described problems by implementing a display using the semiconductor light-emitting element may be proposed.

Recently, such light emitting diode (LED) has been gradually miniaturized and manufactured into a micro-sized LED to be used as a pixel of the display device.

In a large-area display device such as a signage, active matrix (AM) driving is available by packaging a micro IC (a driver IC) with a light source using a micro LED and mounting the package on the display device.

When the driver IC is disposed on the same layer as the LED, a size of the light-emitting element package disposed on a substrate in the display device may increase.

Likewise, as the size of the light-emitting element package increases, the number of transfers of the LED and the driver IC may increase, which may lead to an increase in a process cost.

Further, light emitted from the LED may be absorbed by the driver IC, resulting in a light loss.

Therefore, a method to solve such problem is required.

### SUMMARY

The preset disclosure is to provide a light-emitting element package that may achieve active matrix (AM) driving with the light-emitting element package as an individual pixel, and accordingly, improve an image quality, a display device using the same, and a method for manufacturing the display device.

In addition, the present disclosure is to provide a display device and a method for manufacturing the same that may reduce a size of a light-emitting element in a light-emitting element package.

In addition, the present disclosure is to provide a display device and a method for manufacturing the same that may increase area utilization in the display device.

In addition, the present disclosure is to provide a display device and a method for manufacturing the same that may simplify a structure of a circuit board constituting the display device.

In addition, because a degree of freedom of a substrate applied to a display device may be increased, the present disclosure is to provide a display device and a method for manufacturing the same that enable manufacturing of a display device with a new structure such as a large-area transparent display or the like.

In addition, the present disclosure is to provide a display device and a method for manufacturing the same that may inspect whether a light-emitting element is defective via a probe using a terminal of a light-emitting element package.

Furthermore, according to other embodiments of the present disclosure, those skilled in the art will be able to understand through the entire purpose of the present disclosure and drawings that there may be additional technical problems not mentioned herein.

As a first aspect of the preset disclosure to achieve the above technical task, the present disclosure provides a light-emitting element package including a first layer including a terminal, a second layer (a driving layer) located adjacent to the first layer and including a driving chip, a third layer (a light-emitting layer) located adjacent to the second layer, wherein the third layer includes light-emitting elements, wherein each light-emitting element at least partially overlaps the driving chip in a connection direction of the first layer and the second layer and constitutes a unit subpixel, and a fourth layer located adjacent to the third layer, wherein light emitted from the light-emitting elements passes through the fourth layer, wherein a first electrode of each of the light-emitting elements is connected to a first end of the driving chip and a second end of the driving chip is connected to the terminal.

In one implementation of the first aspect, the first electrode of the light-emitting element may be electrically connected to the first end of the driving chip by a first connection electrode located on a first boundary surface between the second layer and the third layer.

In one implementation of the first aspect, the first boundary surface may further include a second connection electrode connected to a second electrode of the light-emitting element and a power terminal, and a third connection electrode connected to the second end of the driving chip.

In one implementation of the first aspect, the first boundary surface may further include a fourth connection electrode connected to the driving chip and the terminal.

In one implementation of the first aspect, the fourth connection electrode may include a through-electrode extending through the second layer.

In one implementation of the first aspect, the first electrode and a second electrode of the light-emitting element may be electrically connected to the first connection electrode and a second connection electrode, respectively, by conductive particles.

In one implementation of the first aspect, the first electrode and a second electrode of the light-emitting element and the first end and the second end of the driving chip may be arranged to face the first boundary surface.

In one implementation of the first aspect, the first electrode of the light-emitting element may be electrically connected to the first end of the driving chip by a fifth connection electrode located on a first boundary surface between the second layer and the third layer and a sixth connection electrode located on a second boundary surface between the first layer and the second layer.

In one implementation of the first aspect, the fifth connection electrode and the sixth connection electrode may be connected to each other by a through-electrode extending through the second layer.

In one implementation of the first aspect, the first boundary surface may further include a seventh connection electrode connected to a second electrode of the light-emitting element and a power terminal.

In one implementation of the first aspect, the second boundary surface may further include an eighth connection electrode and a ninth connection electrode connected to the second end of the driving chip.

In one implementation of the first aspect, the first end and the second end of the driving chip may be in contact with the second boundary surface.

In one implementation of the first aspect, the first electrode and a second electrode of the light-emitting element and the first end and the second end of the driving chip may be arranged to face the second boundary surface.

In one implementation of the first aspect, at least one of the first to fourth layers may contain light-scattering particles.

In one implementation of the first aspect, the light-scattering particles may be dispersed in a resin layer.

In one implementation of the first aspect, the second layer and the third layer may contain the light-scattering particles of different contents.

In one implementation of the first aspect, the second layer may contain a greater content of the light-scattering particles.

In one implementation of the first aspect, the third layer may include a reflective structure.

In one implementation of the first aspect, the reflective structure may include a reflective cup reflecting light emitted from the light-emitting element.

In one implementation of the first aspect, the reflective cup may be located on a side surface of the light-emitting element and between the light-emitting element and the driving chip.

In one implementation of the first aspect, the light-emitting element package may further include a black matrix located on an outer side of the reflective cup.

In one implementation of the first aspect, the reflective structure may include a reflective inclined surface located in the third layer.

In one implementation of the first aspect, the reflective inclined surface may be located at a border of the third layer.

In one implementation of the first aspect, a black matrix may be located on an outer side of the reflective inclined surface.

In one implementation of the first aspect, the terminal may be connected to a scan line and a data line of a display device and functions as an individual pixel.

In one implementation of the first aspect, the second end of the driving chip may include a column terminal connected to one of the scan line and the data line, a row terminal connected to the other one of the scan line and the data line, a power terminal receiving power, and a ground terminal.

As a second aspect of the preset disclosure to achieve the above technical task, the present disclosure provides a light-emitting element package including a first layer including a terminal, a second layer (a driving layer) located on the first layer and including a driving chip, a third layer (a light-emitting layer) located on the second layer, wherein the third layer includes light-emitting elements driven by the driving chip, wherein each light-emitting element at least partially overlaps the driving chip and constitutes a unit subpixel, and a fourth layer located on the third layer, wherein light emitted from the light-emitting elements passes through the fourth layer, wherein a first electrode of each of the light-emitting elements is connected to a first end of the driving chip and a second end of the driving chip is connected to the terminal.

As a third aspect of the preset disclosure to achieve the above technical task, the present disclosure provides a light-emitting element package including a transparent substrate, a light-emitting layer located on the transparent substrate and including light-emitting elements respectively constituting unit subpixels, a driving layer located on the light-emitting layer and at least partially overlapping the light-emitting layer, wherein the driving layer includes a driving chip electrically connected to the light-emitting elements and driving the light-emitting elements, and a terminal layer located on the driving layer and including a terminal connected to the driving chip.

As a fourth aspect of the preset disclosure to achieve the above technical task, the present disclosure provides a display device including a light-emitting element package defining an individual pixel, wherein the light-emitting element package includes a transparent substrate, a light-emitting layer located on the transparent substrate and including light-emitting elements respectively constituting unit subpixels, a driving layer located on the light-emitting layer and at least partially overlapping the light-emitting layer, wherein the driving layer includes a driving chip electrically connected to the light-emitting elements and driving the light-emitting elements, and a terminal layer located on the driving layer and including a terminal connected to the driving chip.

First, according to one embodiment of the present disclosure, the active matrix (AM) driving may be achieved using the light-emitting element package as the individual pixel, and accordingly, the image quality may be improved.

Additionally, the time-division lighting of the pixels may be achieved, allowing the more pixels to be used for the display, thereby increasing the luminance.

Likewise, as the luminance increases, the size of the light-emitting element in the light-emitting element package may also become smaller. Accordingly, the greater number of pixels may be constructed in the same area size. In other words, the area utilization in the display devices may increase. Therefore, the resolution of the display may be increased. In one example, the material cost of manufacturing the display device may be reduced.

In one example, the structure of the circuit board constituting the display device may be simplified. Accordingly, the manufacturing time may be reduced. Additionally, the manufacturing cost may be reduced.

Additionally, the degree of freedom of the substrate applied to the display device may be increased, so that the display device with the new structure such as the large-area transparent display may be manufactured.

Furthermore, whether the light-emitting element is defective may be inspected via the probe using the terminals of the light-emitting element package. Therefore, the smaller number of light-emitting elements may be used. In other words, the light-emitting element may be saved.

Furthermore, according to another embodiment of the present disclosure, there are additional technical effects not mentioned herein. Those skilled in the art may understand this through the entire contents of the present document and drawings.

### BRIEF DESCRIPTION OF THE DRAWINGS

FIG. 1 is a cross-sectional view showing a light-emitting element package according to a first embodiment of the present disclosure.
FIG. 2 is a cross-sectional view showing a light-emitting element package according to a second embodiment of the present disclosure.
FIG. 3 is a rear view showing a light-emitting element package according to a third embodiment of the present disclosure.
FIG. 4 is a plan view showing a light-emitting element package according to a third embodiment of the present disclosure.
FIG. 5 is a cross-sectional view taken along a line A-A' in FIG. 3.
FIG. 6 is a cross-sectional view taken along a line B-B in FIG. 3.
FIG. 7 is a cross-sectional view showing a light-emitting element package according to a fourth embodiment of the present disclosure.
FIG. 8 is a cross-sectional view showing a light-emitting element package according to a fifth embodiment of the present disclosure.
FIG. 9 is a cross-sectional view showing a light-emitting element package according to a sixth embodiment of the present disclosure.
FIG. 10 is a cross-sectional view showing a light-emitting element package according to a seventh embodiment of the present disclosure.
FIG. 11 is a cross-sectional view showing a light-emitting element package according to an eighth embodiment of the present disclosure.
FIG. 12 is a comparative example and is a schematic diagram showing a display device using a light-emitting element package with a relatively great size as a unit pixel.
FIG. 13 is a schematic diagram showing a display device using a light-emitting element package according to an embodiment of the present disclosure as a unit pixel.
FIGS. 14 to 19 are cross-sectional schematic diagrams showing a manufacturing process of a light-emitting element package 202 according to a second embodiment.
FIGS. 20 to 25 are cross-sectional schematic diagrams showing a manufacturing process of a light-emitting element package 200 according to a first embodiment.
FIG. 26 is a cross-sectional schematic diagram showing a display device using a light-emitting element package according to a first embodiment.
FIG. 27 is a cross-sectional schematic diagram showing a display device using a light-emitting element package according to a second embodiment.
FIG. 28 is a cross-sectional schematic diagram showing a display device using a light-emitting element package according to a third embodiment.

### DESCRIPTION OF SPECIFIC EMBODIMENTS

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

However, it will be readily apparent to those skilled in the art that the configuration according to the embodiments described herein is applicable even to a new product that will be developed later as a display device.

In addition, the semiconductor light emitting device mentioned in this specification is a concept including an LED, a micro LED, and the like, which may be used in a mixed manner.

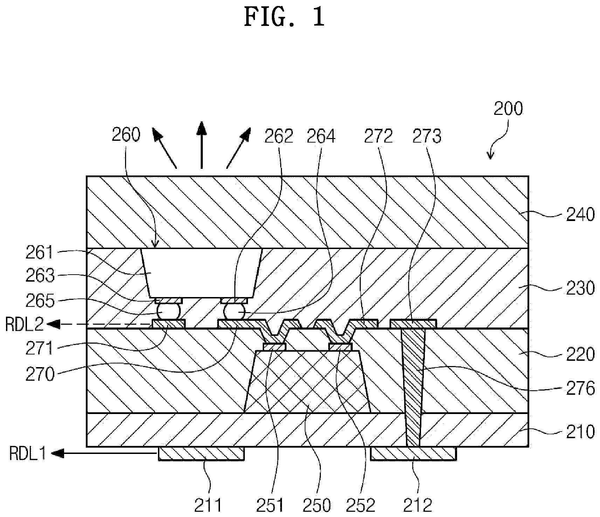

FIG. 1 is a cross-sectional view showing a light-emitting element package according to a first embodiment of the present disclosure.

Referring to FIG. 1, a light-emitting element package 200 according to the first embodiment of the present disclosure may include a light-emitting layer 230 in which a light-emitting element 260 is located, and a driving layer 220 in which a driving chip (a driver IC) 250 that drives the light-emitting element 260 is located.

As such, the light-emitting element package 200 may have the light-emitting layer 230 and the driving layer 220 in different layers. Additionally, the light-emitting element 260 and the driving chip 250 may at least partially overlap each other in a vertical direction.

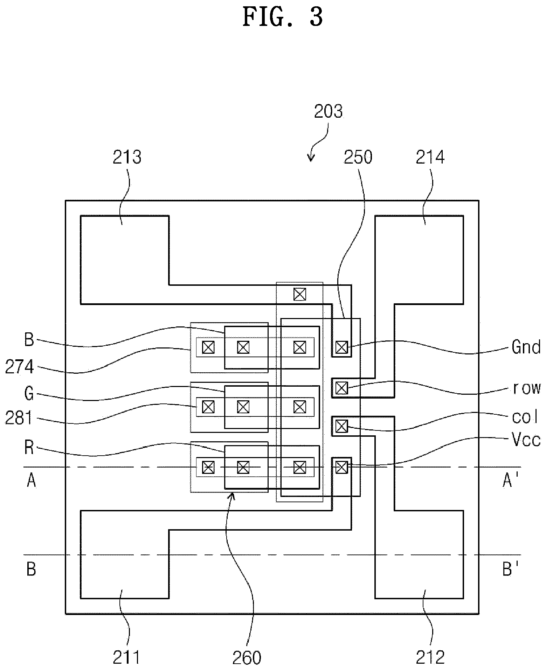

The light-emitting element 260 may include a first light-emitting element R, a second light-emitting element G, and a third light-emitting element B (see FIG. 3). For example, the first light-emitting element may be the red light-emitting element R, the second light-emitting element may be the green light-emitting element G, and the third light-emitting element may be the blue light-emitting element B. In some cases, at least one of the first light-emitting element R, the second light-emitting element G, and the third light-emitting element B may include two or more light-emitting elements.

When the light-emitting element package 200 is used in the display device, each of such first light-emitting element R, second light-emitting element G, and third light-emitting element B may correspond to an individual subpixel. The first light-emitting element R, the second light-emitting element G, and the third light-emitting element B may constitute a unit pixel.

The light-emitting element 260 may be a mini LED with a size in millimeters or a micro LED with a size in micrometers.

Referring to FIG. 1, a layer (hereinafter, referred to as a terminal layer or a first layer) 210 including terminals 211 and 212 may be located on an outer side of the driving layer 220. A layer (hereinafter, referred to as an emitting layer or a fourth layer) 240 through which light emitted from the light-emitting elements 260 passes may be located on an outer side of the light-emitting layer 230.

In the structure shown in FIG. 1, the light-emitting element package 200 may be composed of the first layer 210 including the terminals 211 and 212, the second layer (the driving layer) 220 located adjacent to the first layer 210 and including the driving chip 250, the third layer (the light-emitting layer) 230 located adjacent to the second layer 220 and including the light-emitting elements 260, each of which at least partially overlaps the driving chip 250 and constitutes a unit subpixel, and the fourth layer (emitting layer) 240 located adjacent to the third layer 230 and through which light emitted from the light-emitting elements 260 passes.

For example, the light-emitting element package 200 according to the present embodiment may be a top emission package in which light is emitted in an upward direction.

In this regard, the driving chip 250 and the light-emitting elements 260 may overlap in a connection direction (i.e., the vertical direction in FIG. 1) of connecting the first layer 210 with the second layer 220.

The driving chip 250 may be a micro driving integrated circuit chip (the driver IC) that may selectively drive the light-emitting elements 260 with current.

The individual light-emitting element 260 may include a first electrode 262 and a second electrode 263 that are in contact with a semiconductor structure 261.

In this regard, in each of the light-emitting elements 260, the first electrode 262 may be electrically connected to a first end 251 of the driving chip 250, and a second end 252 of the driving chip 250 may be connected to the terminal 211 or 212.

As an exemplary embodiment, the first electrode 262 of the light-emitting element 260 may be electrically connected to the first end 251 of the driving chip 250 by a first connection electrode 270. Such first connection electrode 270 may be located on a first boundary surface (a first redistribution layer) RDL2 between the second layer (the driving layer) 220 and the third layer (the light-emitting layer) 230.

Additionally, referring to FIG. 1, a second connection electrode 271 to which the second electrode 263 of the light-emitting element 260 and a power terminal of the light-emitting element package 200 are connected may be located on the first boundary surface RDL2. Additionally, the first boundary surface (the first redistribution layer) RDL2 may further include a third connection electrode 272 connected to the second end 252 of the driving chip 250.

In one embodiment, the first boundary surface RDL2 may further include a fourth connection electrode 273 to which the driving chip 250 and the terminals 211 and 212 are connected. For example, the fourth connection electrode 273 may include a through-electrode 276 that extends through the second layer 220.

As such, as an exemplary embodiment, at least one of the first connection electrode 270 to the fourth connection electrode 273 may be located on the first boundary surface RDL2.

For example, the first electrode 262 and the second electrode 263 of the light-emitting element 260 and the first end 251 and the second end 252 of the driving chip 250 may be arranged to face each other. In other words, the first electrode 262 and the second electrode 263 of the light-emitting element 260 and the first end 251 and second end 252 of the driving chip 250 may be arranged to face the first boundary surface RDL2.

As an exemplary embodiment, the first electrode 262 and the second electrode 263 of the light-emitting element 260 may be electrically connected to the first connection electrode 270 and the second connection electrode 271, respectively, by conductive particles 264 and 265.

At least one of such first connection electrode 270 to fourth connection electrode 273 may be manufactured using a redistribution layer (RDL) process used in a semiconductor package process.

Using such redistribution layer (RDL) process, the terminals (the first end and the second end) 251 and 252 of the driving chip 250 and the light-emitting elements 260 may be connected to each other.

Additionally, the terminals 211 and 212 may be located on a second boundary surface (a second redistribution layer) RDL1 formed in the first layer 210.

At least one of the first layer 210 to the fourth layer 240 may include an insulating layer. For example, at least one of the first layer 210 to the fourth layer 240 may be formed as the insulating layer.

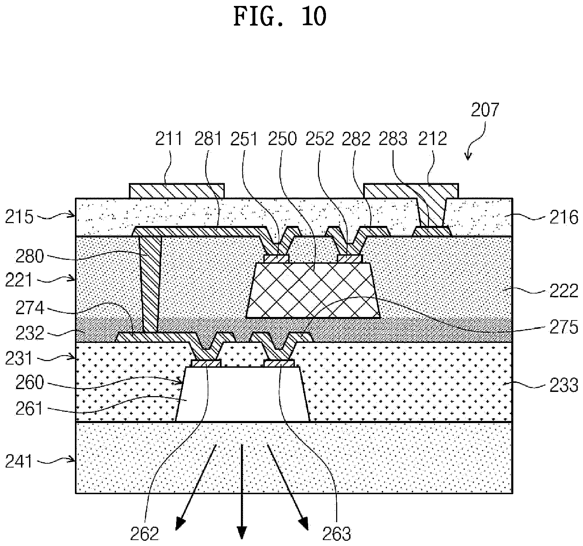

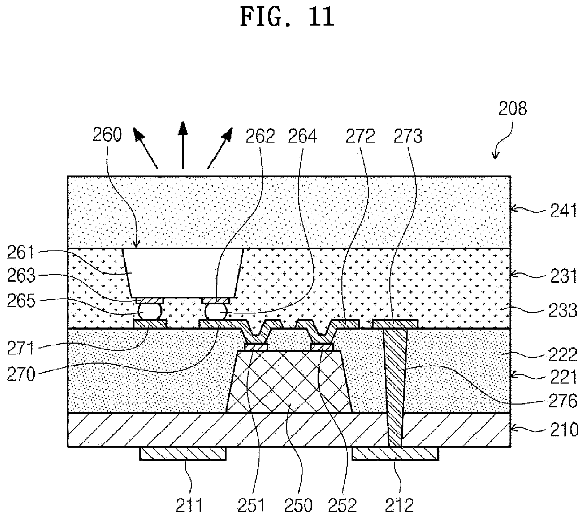

In one example, at least one of the first layer 210 to the fourth layer 240 may contain particulates. Such particulates may have a size in micrometers or nanometers. Such particulates may be light-scattering particles. Such particulates may have a refractive index equal to or higher than 1.3. This will be described later with reference to FIGS. 10 and 11.

Such particulates may include at least one of metal oxides, resin particles, and inorganic oxides. For example, the particulates may include at least one of TiOz, ZnOz, ZrOz, MgF₂, SnO₂, ITO, SiNx, silica, and PMMA.

When the particulates are applied to at least one of the first layer 210 to the fourth layer 240, at least one of a material, a particle size, and a content thereof may be different in each layer.

In the top emission package structure as shown in FIG. 1, for example, the particulates may be used to improve a viewing angle to prevent color temperature deviation depending on a light emission angle of the light-emitting element 260 in the fourth layer 240.

In one example, the particulates may be used to improve efficiency and the viewing angle in the third layer 230. In this regard, haziness and reflectance of the fourth layer 240 may be lower than those of the third layer 230. When the same particles are applied, the particle content of the fourth layer 240 may be smaller than that of the third layer 230.

In the structure shown in FIG. 1, a specific example of each layer is as follows.

The first layer 210 may function as an adhesive layer for transferring the driving chip 250 during a manufacturing process of the light-emitting element package 200. Such first layer 210 may be in contact with the terminals 211 and 212 constituting the second redistribution layer RDL1 or may surround the terminals 211 and 212.

The second layer 220, as the driving layer in which the driving chip 250 is located, may have a structure for composition of the connection electrodes 270 to 273 constituting the first redistribution layer RDL2 and fan-out of the terminals (the first end and the second end) 251 and 252 of the driving chip 250. The second layer 220 may be made of a transparent material or may be a resin layer containing the particulates.

The third layer 230, as the light-emitting layer in which the light-emitting element 260 is located, may contain a bonding material for bonding the light-emitting element 260. Like the second layer 220, the third layer 230 may be made of the transparent material or may be the resin layer containing the particulates.

The fourth layer 240, as a layer through which light from the light-emitting element 260 is emitted, may play a role in protecting the light-emitting element 260. The fourth layer 240 may be made of a transparent material including transparent resin such as acryl, epoxy, and silicone.

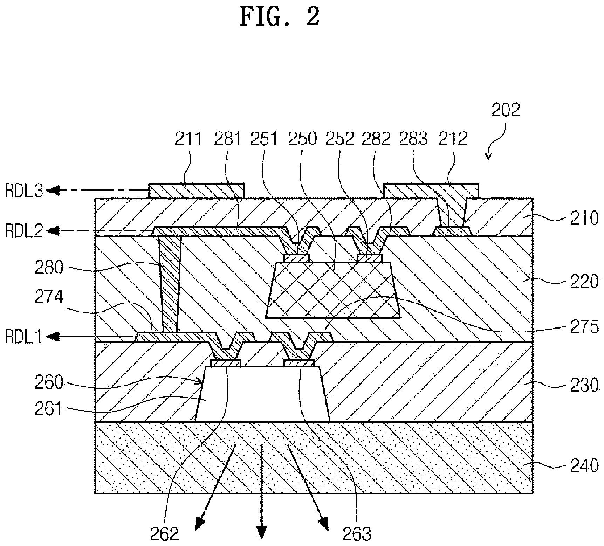

FIG. 2 is a cross-sectional view showing a light-emitting element package according to a second embodiment of the present disclosure.

Referring to FIG. 2, the light-emitting element package 200 according to the second embodiment of the present disclosure may include the light-emitting layer 230 in which the light-emitting element 260 is located and the driving layer 220 in which the driving chip (the driver IC) 250 that drives the light-emitting element 260 is located.

As such, the light-emitting element package 200 may have the light-emitting layer 230 and the driving layer 220 in different layers. Additionally, the light-emitting element 260 and the driving chip 250 may at least partially overlap each other in the vertical direction.

Referring to FIG. 2, the layer (hereinafter, referred to as the terminal layer or the first layer 210) including the terminals 211 and 212 may be located on an outer side of (on top of) the driving layer 220. The layer (hereinafter, referred to as a cover layer or the fourth layer 240) through which light emitted from the light-emitting elements 260 passes may be located on an outer side of (beneath) the light-emitting layer 230.

In the structure shown in FIG. 2, the light-emitting element package 200 may be composed of the first layer 210 including the terminals 211 and 212, the second layer (the driving layer) 220 located adjacent to the first layer 210 and including the driving chip 250, the third layer (the light-emitting layer) 230 located adjacent to the second layer 220 and including the light-emitting elements 260, each of which at least partially overlaps the driving chip 250 and constitutes the unit subpixel, and the fourth layer 240 located adjacent to the third layer 230 and through which light emitted from the emitting elements 260 passes.

For example, the light-emitting element package 200 according to the present embodiment may be a bottom emission package in which light is emitted in a downward direction.

In this regard, the driving chip 250 and the light-emitting elements 260 may overlap in the connection direction (i.e., the vertical direction in FIG. 2) of connecting the first layer 210 with the second layer 220.

The driving chip 250 may be the micro driving integrated circuit chip (the driver IC) that may selectively drive the light-emitting elements 260 with the current.

The individual light-emitting element 260 may include the first electrode 262 and the second electrode 263 that are in contact with the semiconductor structure 261.

Hereinafter, descriptions redundant with the description of FIG. 1 will be omitted.

In this regard, the first electrode 262 of each of the light-emitting elements 260 may be electrically connected to the first end 251 of the driving chip 250, and the second end 252 of the driving chip 250 may be connected to the terminal 211 or 212.

As an exemplary embodiment, the first electrode 263 of the light-emitting element 260 may be electrically connected to the first end 251 of the driving chip 250 by a fifth connection electrode 274 located on the first boundary surface (first redistribution layer) RDL1 between the second layer 220 and the third layer 230 and a sixth connection electrode 281 located on the second boundary surface (the second redistribution layer) RDL2 between the first layer 210 and the second layers 220.

As such, the locations and the connection relationship of the first redistribution layer RDL1 and the second redistribution layer RDL2 according to the present second embodiment may be different from the locations and the connection relationship of the first redistribution layer RDL2 and the second redistribution layer RDL1 according to the first embodiment described above with reference to FIG. 1.

In this regard, the fifth connection electrode 274 and the sixth connection electrode 281 may be connected to each other by a through-electrode 280 extending through the second layer 220.

As an exemplary embodiment, the first boundary surface RDL1 may further include a seventh connection electrode 275 to which the second electrode 263 of the light-emitting element 260 and the power terminal are connected.

Additionally, the second boundary surface RDL2 may further include an eighth connection electrode 282 and a ninth connection electrode 283 connected to the second end 252 of the driving chip 250.

In this regard, the first end 251 and the second end 252 of the driving chip 250 may be in contact with the second boundary surface RDL2.

As an exemplary embodiment, the first electrode 262 and the second electrode 263 of the light-emitting element 260, and the first end 251 and the second end 252 of the driving chip 250 may be arranged to face the second boundary surface RDL2.

At least one of such fifth to ninth connection electrodes 274 to 283 may be manufactured using the redistribution layer (RDL) process used in the semiconductor package process.

Using such redistribution layer (RDL) process, the terminals (the first end and the second end) 251 and 252 of the driving chip 250 and the light-emitting elements 260 may be connected to each other.

Additionally, the terminals 211 and 212 may be located on a third boundary surface (a third redistribution layer) RDL3 formed in the first layer 210.

At least one of the first layer 210 to the fourth layer 240 may include the insulating layer. For example, at least one of the first layer 210 to the fourth layer 240 may be formed as the insulating layer.

In one example, at least one of the first layer 210 to the fourth layer 240 may contain the particulates. Such particulates may have the size in micrometers or nanometers. Such particulates may be the light-scattering particles. Such particulates may have the refractive index equal to or higher than 1.3. This will be described later with reference to FIGS. 10 and 11.

Such particulates may include at least one of the metal oxides, the resin particles, and the inorganic oxides. For example, the particulates may include at least one of TiO₂, ZnO₂, ZrO₂, MgF₂, SnO₂, ITO, SiNx, silica, and PMMA.

When the particulates are applied to at least one of the first layer 210 to the fourth layer 240, at least one of the material, the particle size, and the content thereof may be different in each layer.

In the bottom emission package structure as shown in FIG. 2, for example, the particulates may be used to improve the viewing angle to prevent the color temperature deviation depending on the light emission angle of the light-emitting element 260 in the fourth layer 240.

In one example, the particulates may be used to improve the efficiency and the viewing angle in the third layer 230. In this regard, the haziness and the reflectance of the fourth layer 240 may be lower than those of the third layer 230. When the same particles are applied, the particle content of the fourth layer 240 may be smaller than that of the third layer 230.

In the structure shown in FIG. 3, a specific example of each layer is as follows.

Light emitted from the light-emitting element 260 may be emitted through the fourth layer 240. The fourth layer 240 may be made of the transparent material including the transparent resin such as the acryl, the epoxy, and the silicone.

The third layer 230, as the light-emitting layer in which the light-emitting element 260 is located. As mentioned above, the third layer 230 may be the resin layer containing the particulates to improve the efficiency of the light-emitting element 260.

The second layer 220, as the driving layer in which the driving chip 250 is located, may be made of the transparent material or, like the third layer 230, may be the resin layer containing the particulates. The second layer 220 may include an adhesive layer 232 (see FIG. 10) for transferring the driving chip 250 during the manufacturing process of the light-emitting element package 200.

The first layer 210 may include the insulating layer for forming a macro terminal for connecting the terminals (the first end and the second end 251 and 252) of the driving chip 250 to an external wiring substrate. Such first layer 210 may also contain the particulates.

Other components not described may be the same as those in the first embodiment described with reference to FIG. 1.

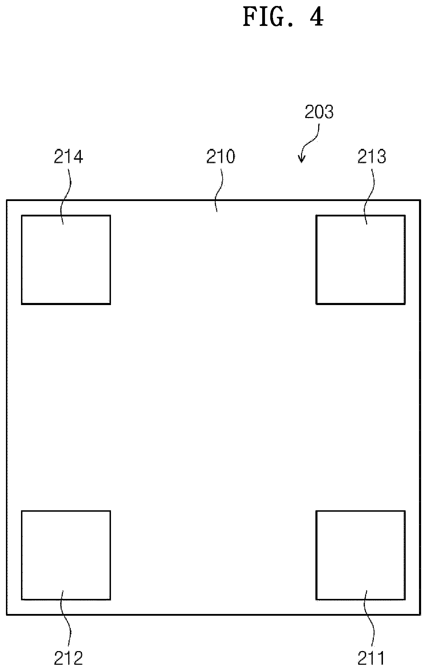

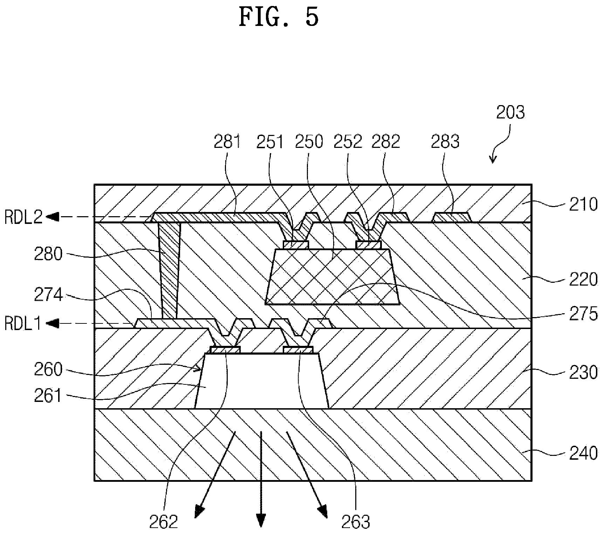

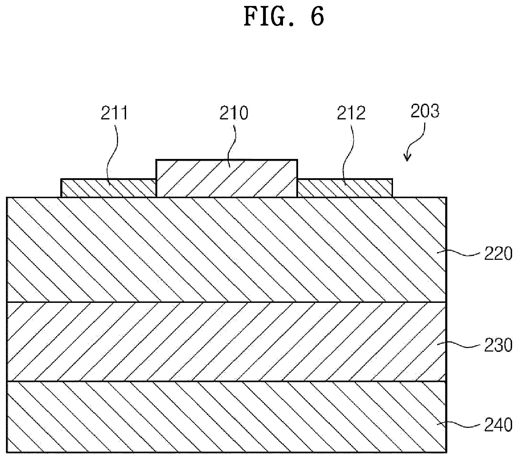

FIG. 3 is a rear view showing a light-emitting element package according to a third embodiment of the present disclosure. FIG. 4 is a plan view showing a light-emitting element package according to a third embodiment of the present disclosure. FIG. 5 is a cross-sectional view taken along a line A-A' in FIG. 3, and FIG. 6 is a cross-sectional view taken along a line B-B in FIG. 3.

Such third embodiment may be substantially the same as the second embodiment described above. For example, other than the locations of the terminals 211 to 214 and relative locations of the terminals 211 to 214 in the first layer 210, the third embodiment may be the same as the second embodiment.

Therefore, hereinafter, with reference to FIGS. 3 to 5, differences from such second embodiment will be mainly described.

Referring to FIGS. 3 and 5, the first end 251 of the driving chip 250 may be connected to the light-emitting elements 260, and the second end 252 of the driving chip 250 may include a column terminal col and a row terminal row connected to a row signal, a power terminal Vcc that receives power, and a ground terminal Gnd.

The terminal may include the first terminal 211 connected to the power terminal Vcc, the second terminal 212 connected to the column terminal col, a third terminal 213 connected to the ground terminal Gnd, and a fourth terminal 214 connected to the row terminal row.

In an embodiment in which a light-emitting element package 203 constitutes a unit pixel of the display device, one of the column terminal col and the row terminal row may be connected to a scan electrode of the display device and the other may be connected to a data electrode of the display device.

As such, the individual light-emitting element package 203 may be connected to the scan electrode and the data electrode of the display device via the terminals 211 to 214. When a pixel signal is applied from the scan electrode and the data electrode via the terminals 211 to 214 in the display device, such pixel signal may be transmitted to the driving chip 250 and the driving chip 250 may drive the light-emitting elements 260 in response to the pixel signal to emit light corresponding to the corresponding pixel.

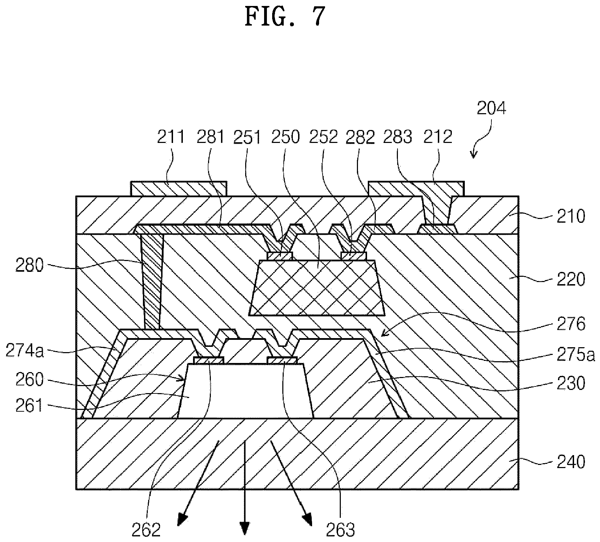

FIG. 7 is a cross-sectional view showing a light-emitting element package according to a fourth embodiment of the present disclosure.

FIG. 7 shows an embodiment of the bottom emission structure similar to the second and third embodiments described above.

Referring to FIG. 7, the third layer 230 of a light-emitting element package 204 may include a reflective structure 276. For example, the reflective structure 276 in a form of reflective cups 274a and 275a through which the light emitted from the light-emitting element 260 is reflected may be disposed on an outer side of the light-emitting element 260 located in the third layer (the light-emitting layer) 230.

Such reflective cups 274a and 275a may reflect light emitted from the light-emitting element 260 in a direction of the fourth layer (the emitting layer) 240.

In this regard, the reflective cups 274a and 275a may be formed as the fifth connection electrode 274 located on the first boundary surface (the first redistribution layer) RDL1 and connecting the first electrode 262 of the light-emitting element 260 with the ground terminal and the seventh connection electrode 275 located on the first boundary surface RDL1 and connecting the second electrode 263 of the light-emitting element 260 with the power terminal are modified. In this regard, the first boundary surface (the first redistribution layer) RDL1 may not be clearly distinguished.

In other words, the fifth connection electrode 274a connecting the first electrode 262 of the light-emitting element 260 with the ground terminal and the seventh connection electrode 275a connecting the second electrode 263 of the light-emitting element 260 with the power terminal may be formed in the reflective cup shape that may reflect light emitted from the light-emitting element 260 in the direction of the fourth layer (the emitting layer) 240.

Accordingly, the reflective cups 274a and 275a may be electrically separated from each other.

Such reflective cups 274a and 275a may be located on a side surface of the light-emitting element 260 and between the light-emitting element 260 and the driving chip 250.

Other components not described may be the same as those in the descriptions of the second and third embodiments.

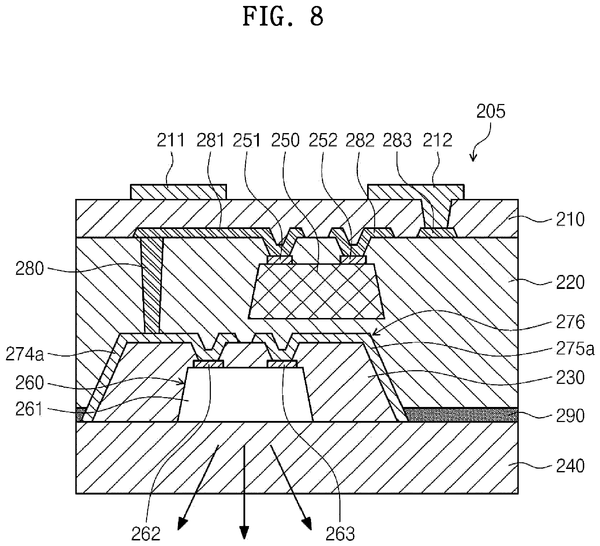

FIG. 8 is a cross-sectional view showing a light-emitting element package according to a fifth embodiment of the present disclosure.

Referring to FIG. 8, the third layer 230 of a light-emitting element package 205 may include the reflective structure 276. As in FIG. 7, the reflective cups 274a and 275a that reflect light emitted from the light-emitting element 260 may be disposed on the outer side of the light-emitting element 260 located in the third layer (the light-emitting layer) 230 of the light-emitting element package 205.

In this regard, a black matrix 290 may be disposed on an outer side of the reflective cups 274a and 275a. Such black matrix 290 may be positioned parallel to the fourth layer (the emitting layer) 240. For example, the black matrix 290 may be in contact with the fourth layer 240.

In this regard, the fifth connection electrode 274a that connects the first electrode 262 of the light-emitting element 260 with the ground terminal and the seventh connection electrode 275a that connects the second electrode 263 of the light-emitting element 260 with the power terminal may be formed in the reflective cup shape that may reflect light emitted from the light-emitting element 260 in the direction of the fourth layer (the emitting layer) 240.

Other components not described may be the same as those in the descriptions of the second to fourth embodiments.

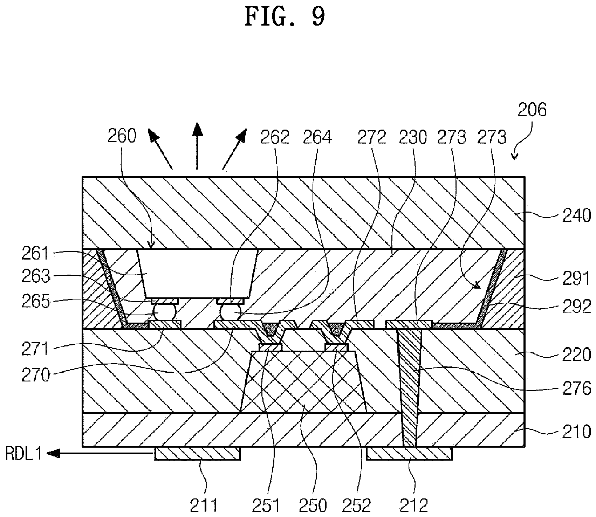

FIG. 9 is a cross-sectional view showing a light-emitting element package according to a sixth embodiment of the present disclosure.

FIG. 9 shows an embodiment of the top emission structure similar to the first embodiment described above.

Referring to FIG. 9, the third layer (the light-emitting layer) 230 of a light-emitting element package 206 may include a reflective structure 277. As an exemplary embodiment, the reflective structure 277 may include a reflective inclined surface 292 located in the third layer 230.

For example, the reflective inclined surface 292 may be located at a border of the third layer 230. Such reflective inclined surface 292 may have an inclination such that light emitted from the light-emitting element 260 is emitted toward the fourth layer (the emitting layer) 240.

In other words, the reflective inclined surface 292 may reflect light emitted from the light-emitting element 260 in the direction of the fourth layer (the emitting layer) 240.

For example, a black matrix 291 may be located on an outer side of the reflective inclined surface 292. In other words, a side opposite to a reflective surface of the reflective inclined surface 292 may be filled with a dark-colored material that may act as the black matrix 291.

A remaining structure may be the same as the structure in the first embodiment described with reference to FIG. 1. That is, other components not described may be the same as those in the description of the first embodiment.

FIG. 10 is a cross-sectional view showing a light-emitting element package according to a seventh embodiment of the present disclosure.

Referring to FIG. 10, a light-emitting element package 207 represents an embodiment of the bottom emission structure similar to the second embodiment described above with reference to FIG. 2.

Referring to FIG. 10, as described above, at least one of a first layer 215 to a fourth layer 241 may include the insulating layer. For example, at least one of the first layer 215 to the fourth layer 241 may be formed as the insulating layer.

In one example, as described above, at least one of the first layer 215 to the fourth layer 241 may contain the particulates. Such particulates may contain the light-scattering particles. Such light-scattering particles may be dispersed in the resin layer constituting the insulating layer.

Referring to FIG. 10, light emitted from the light-emitting element 260 may be emitted through the fourth layer 241. The fourth layer 241 may be made of the transparent material including the transparent resin such as the acryl, the epoxy, or the silicone. Such fourth layer 241 may be formed using the particulates.

A third layer 231, as a light-emitting layer in which the light-emitting element 260 is located, may be made of a resin layer containing particulates 233 to improve the efficiency of the light-emitting element 260, as described above.

A second layer 221, as a driving layer in which the driving chip 250 is located, may be made of a transparent material or, like the third layer 231, may be made of a resin layer containing particulates 222. The second layer 221 may include the adhesive layer 232 for transferring the driving chip 250 during the manufacturing process of the light-emitting element package 200.

As an exemplary embodiment, the second layer (the driving layer) 221 and the third layer 231 may contain the light-scattering particles of different contents.

For example, the second layer 221 may contain a greater content of the light-scattering particles than the third layer 231.

The first layer 215 may include an insulating layer for forming the macro terminal for connecting the terminals (the first end and the second end 251 and 252) of the driving chip 250 to the external wiring substrate. Such first layer 215 may also include particulates 216.

Other components not described may be the same as those in the second embodiment described with reference to FIG. 2.

FIG. 11 is a cross-sectional view showing a light-emitting element package according to an eighth embodiment of the present disclosure.

Referring to FIG. 11, a light-emitting element package 208 represents an embodiment of the top emission structure similar to the first embodiment described above with reference to FIG. 1.

Referring to FIG. 11, as described above, at least one of the first layer 210 to the fourth layer 241 may include the insulating layer. For example, at least one of the first layer 210 to the fourth layer 241 may be formed as the insulating layer.

In one example, as described above, at least one of the first layer 210 to the fourth layer 241 may contain the particulates. Such particulates may include the light-scattering particles. Such light-scattering particles may be dispersed in the resin layer that constitutes the insulating layer.

Referring to FIG. 11, light emitted from the light-emitting element 260 may be emitted through the fourth layer 241. The fourth layer 241 may be made of the transparent material including the transparent resin such as the acryl, the epoxy, and the silicone. Such fourth layer 241 may be formed using the particulates.

The third layer 231, as the light-emitting layer in which the light-emitting element 260 is located, may be the resin layer containing the particulates 233 to improve the efficiency of the light-emitting element 260, as described above.

The second layer 221, as the driving layer in which the driving chip 250 is located, may be made of the transparent material or, like the third layer 231, may be the resin layer containing the particulates 222.

As an exemplary embodiment, the second layer (the driving layer) 221 and the third layer 231 may contain the light-scattering particles of the different contents.

For example, the second layer 221 may contain the greater content of the light-scattering particles than the third layer 231.

The first layer 210 may include the insulating layer for forming the macro terminal for connecting the terminals (the first end and the second end 251 and 252) of the driving chip 250 to the external wiring substrate.

Other components not described may be the same as those in the first embodiment described with reference to FIG. 1.

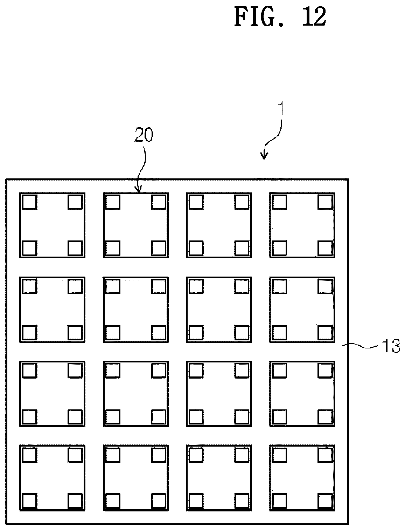

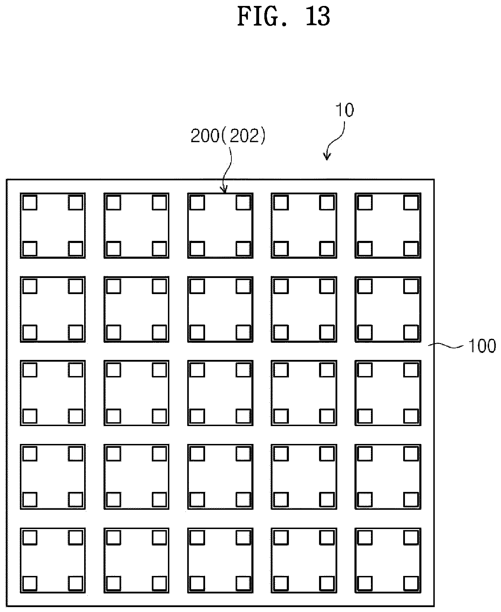

FIG. 12 is a comparative example and is a schematic diagram showing a display device using a light-emitting element package with a relatively great size as a unit pixel. FIG. 13 is a schematic diagram showing a display device using a light-emitting element package according to an embodiment of the present disclosure as a unit pixel.

In a large-area display device such as a signage, when the micro IC (the driving chip) 250 is packaged with a light source using the micro LED (the light-emitting element) 260 as in the embodiment of the present disclosure and the package is mounted on the display device, active matrix (AM) driving may be achieved.

Advantages of the AM driving using such light-emitting element package 200 are as follows.

First, an image quality may be improved by the AM driving.

Additionally, time-division lighting of the pixels may be achieved, allowing more pixels to be used for the display, thereby increasing luminance.

Likewise, as luminance increases, a size of the light-emitting element 260 may also become smaller. Accordingly, a greater number of pixels may be constructed in the same area size. In other words, the area utilization in the display devices may increase. Therefore, a resolution of the display may be increased. In one example, a material cost of manufacturing the display device may be reduced.

In one example, the structure of the circuit board constituting the display device may be simplified. Accordingly, a manufacturing time may be reduced. Additionally, a manufacturing cost may be reduced.

Additionally, the degree of freedom of the substrate applied to the display device may be increased, so that the display device with the new structure such as the large-area transparent display may be manufactured.

Furthermore, whether the light-emitting element 260 is defective may be inspected via a probe using the terminals 211 to 214 of the light-emitting element package 200. Usually, it is difficult to inspect whether the light-emitting element 260 is defective in advance, so that preparations such as having extra light-emitting elements are made, but because such preparations are unnecessary, a smaller number of light-emitting elements 260 may be used. In other words, the light-emitting element 260 may be saved.

When the driving chip 250 is disposed in the same layer as the light-emitting element 260, a size of a light-emitting element package 20 disposed on a substrate 13 in a display device 1 may increase, as shown in FIG. 12.

As such, as the size of the light-emitting element package 20 increases, the number of transfers of the light-emitting element 260 and the driving chip 250 may increase, which may lead to an increase in a process cost.

In one example, light emitted from the light-emitting element 260 may be absorbed by the driving chip 250, resulting in a light loss.

However, as in the embodiment of the present disclosure, when the light-emitting element 260 and the driving chip 250 may be formed as the separate layers, the size of the light-emitting element package 200 may be reduced, and such disadvantage may be resolved.

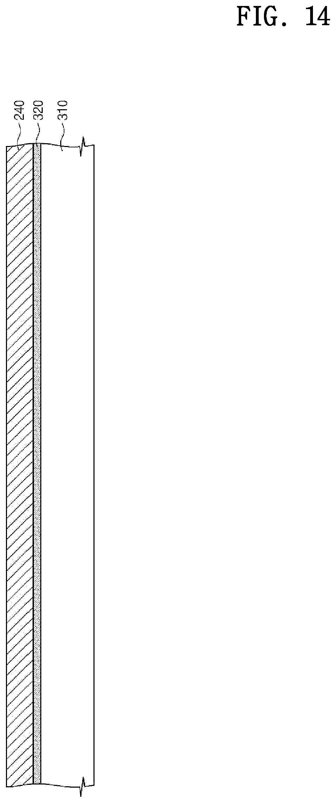

FIGS. 14 to 19 are cross-sectional schematic diagrams showing a manufacturing process of a light-emitting element package 202 according to a second embodiment.

Hereinafter, with reference to FIGS. 14 to 19, the manufacturing process of the light-emitting element package 202 will be described step by step.

First, referring to FIG. 14, with a sacrificial layer 320 positioned on a base substrate 310, the fourth layer 240 may be formed.

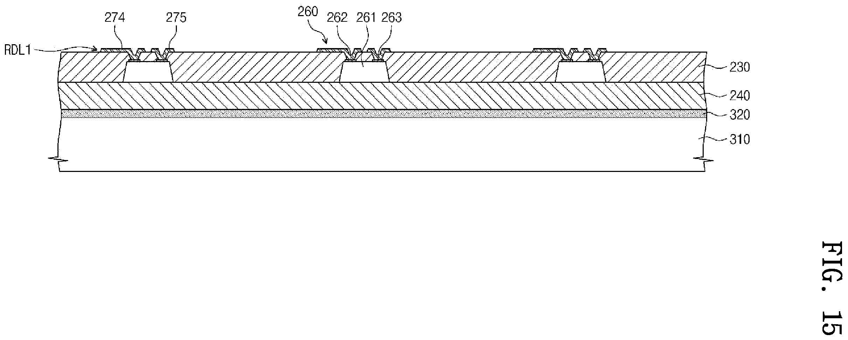

Thereafter, as shown in FIG. 15, the third layer (the light-emitting layer) 230 may be formed.

For example, with the red R, green G, and blue B light-emitting elements 260 arranged at a regular spacing on the fourth layer 240, the third layer 230 may be formed to have a greater vertical dimension than the light-emitting element 260.

In this regard, the first redistribution layer RDL1 may be formed with the first electrode 262 and the second electrode 263 of the light-emitting element 260 opened. That is, in contact with the third layer 230, the fifth connection electrode 274 connected to the first electrode 262 of the light-emitting element 260 and the seventh connection electrode 275 connected to the second electrode 263 of the light-emitting element 260 may be formed.

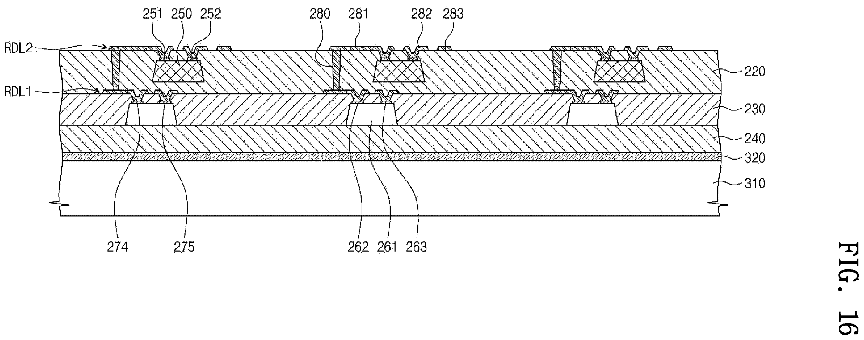

Next, referring to FIG. 16, the second layer (the driving layer) 220 may be formed.

For example, the driving chip 250 may be transferred with the adhesive layer 232 (see FIG. 10) formed on the third layer (the light-emitting layer) 230.

Thereafter, with the second layer 220 formed, the first end 251 and the second end 252 of the driving chip 250 opened, and a via hole into which the through-electrode 280 is to be formed defined, the second redistribution layer RDL2 may be formed. That is, the through-electrode 280, the sixth connection electrode 281, the eighth connection electrode 282, and the ninth connection electrode 283 may be manufactured.

As described above, the fifth connection electrode 274 and the sixth connection electrode 281 may be connected to each other by the through-electrode 280 extending through the second layer 220.

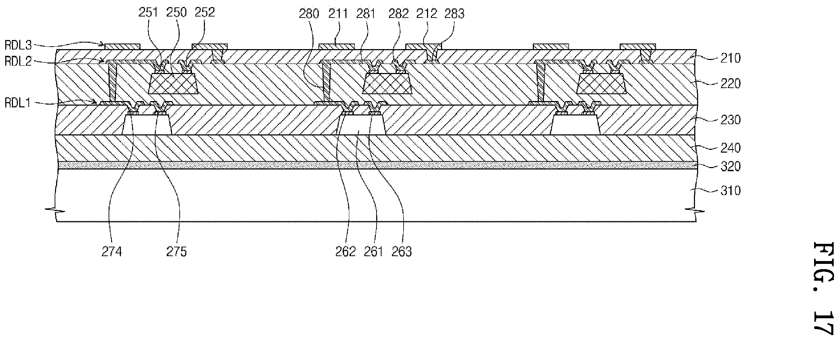

Thereafter, referring to FIG. 17, the first layer 210 may be formed.

For example, with the first layer 210 formed and the ninth connection electrode 283 opened, the third redistribution layer RDL3 may be formed. That is, the terminals 211 to 214 may be manufactured. In this regard, the ninth connection electrode 283 may be connected to the second terminal 212.

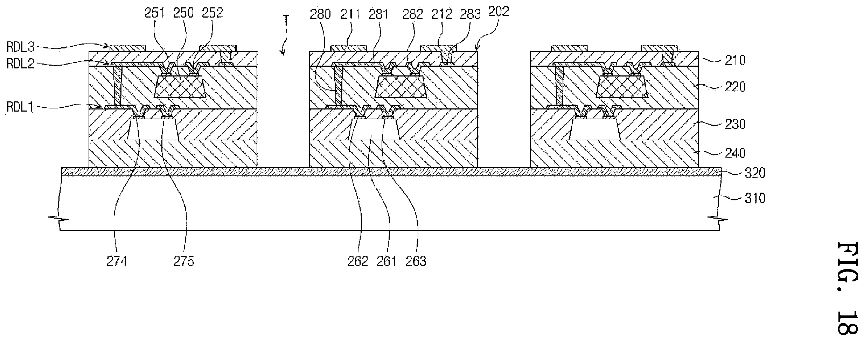

Next, referring to FIG. 18, a trench area T separated by the individual packages 202 may be defined.

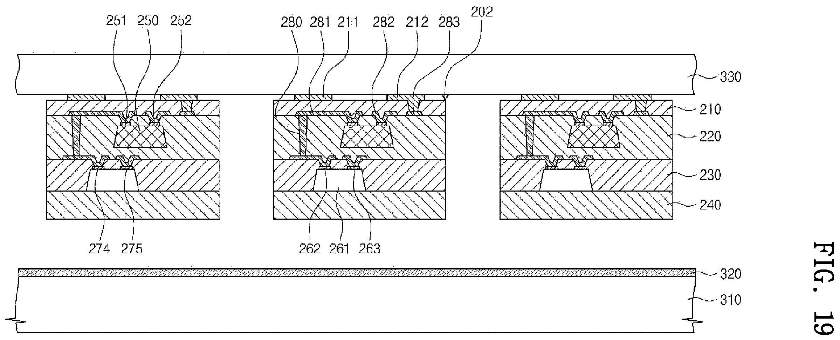

Thereafter, as shown in FIG. 19, the base substrate 310 may be removed by removing the sacrificial layer 320 while an adhesive film 330, such as a UV adhesive film, is attached to the first layer 210.

Thereafter, when the individual light-emitting element packages 202 are removed from the adhesive film 330, the light-emitting element packages 202 having the structure as shown in FIG. 2 may be manufactured.

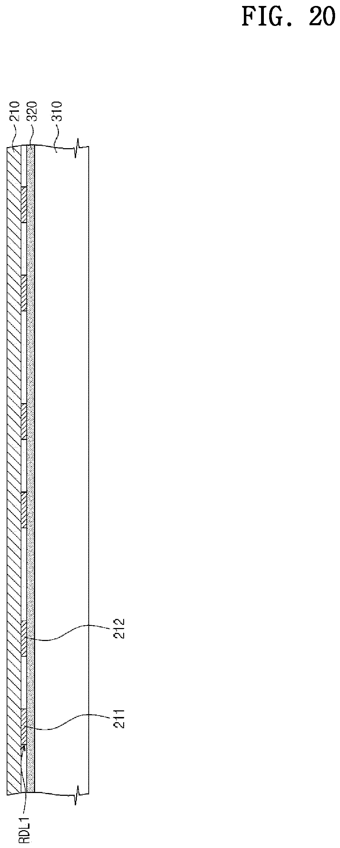

FIGS. 20 to 25 are cross-sectional schematic diagrams showing a manufacturing process of a light-emitting element package 200 according to a first embodiment.

Hereinafter, with reference to FIGS. 20 to 25, the manufacturing process of the light-emitting element package 200 will be described step by step.

First, referring to FIG. 20, with the sacrificial layer 320 positioned on the base substrate 310, the first layer 210 may be formed.

For example, the first redistribution layer RDL1 may be formed on the sacrificial layer 320. That is, the first layer 210 may be formed with the terminals 211 to 214 manufactured on the sacrificial layer 320.

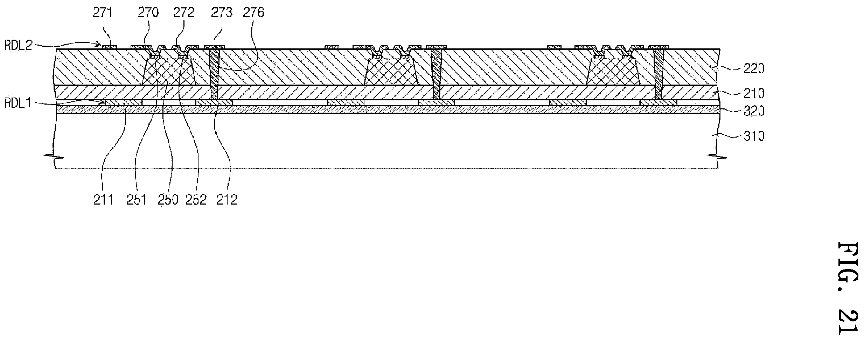

Thereafter, as shown in FIG. 21, the second layer (the driving layer) 220 may be formed.

For example, the driving chip 250 may be transferred onto the first layer 220.

Thereafter, with the second layer 220 formed, the first end 251 and the second end 252 of the driving chip 250 opened, and a via hole in which the through-electrode 276 is to be formed defined, the second redistribution layer RDL2 may be formed. That is, the first connection electrode 270, the second connection electrode 271, the third connection electrode 272, and the fourth connection electrode 273 may be manufactured on the second layer 220.

As described above, the fourth connection electrode 273 may include the through-electrode 276 extending through the second layer 220.

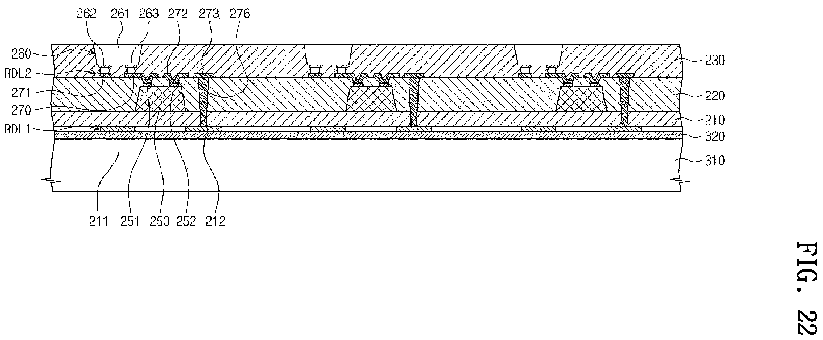

Next, referring to FIG. 22, the third layer (the light-emitting layer) 230 may be formed.

For example, first, the first electrode 262 and the second electrode 263 of the light-emitting element 260 may be connected onto the first connection electrode 270 and the second connection electrode 271, respectively.

As described above, the first electrode 262 and the second electrode 263 of the light-emitting element 260 may be electrically connected to the first connection electrode 270 and the second connection electrode 271, respectively, by the conductive particles 264 and 265.

Thereafter, the third layer 230 may be filled and formed on a side surface of the light-emitting element 260.

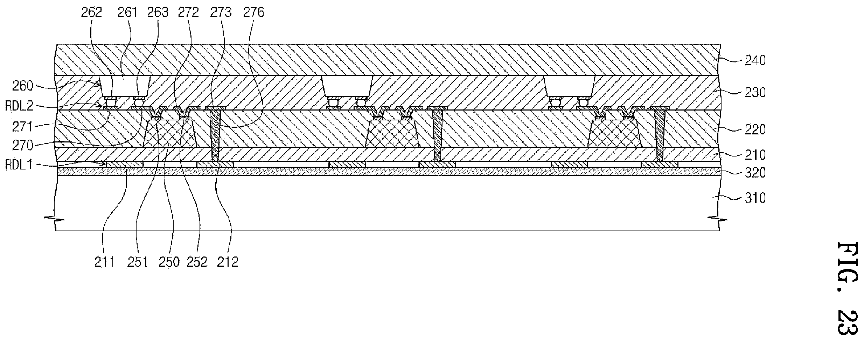

Next, referring to FIG. 23, the fourth layer 240 may be formed.

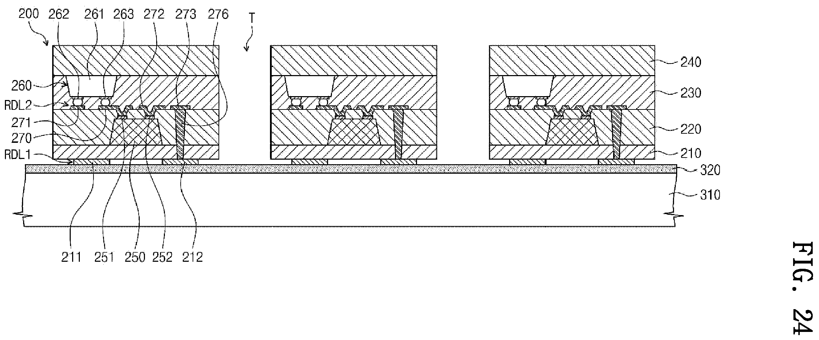

Thereafter, referring to FIG. 24, the trench area T separated by the individual packages 200 may be defined.

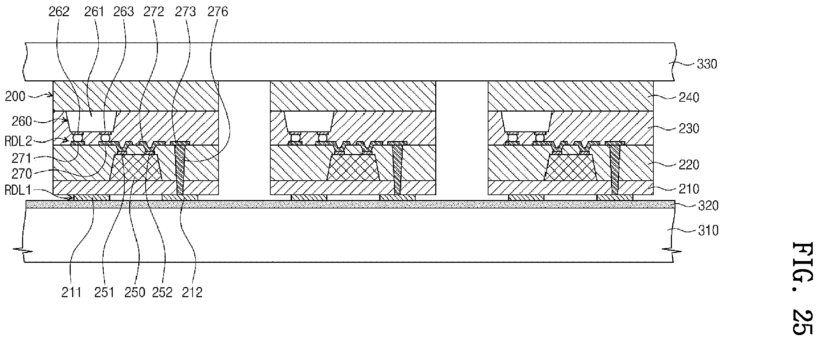

Thereafter, as shown in FIG. 25, the adhesive film 330, such as the UV adhesive film, may be attached on the first layer 210.

Next, the base substrate 310 may be removed by removing the sacrificial layer 320.

Thereafter, when the individual light-emitting element packages 202 are removed from the adhesive film 330, the light-emitting element packages 200 having the structure as shown in FIG. 1 may be manufactured.

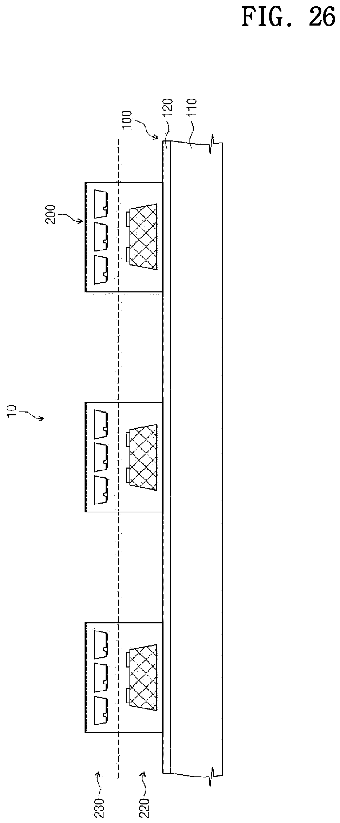

FIG. 26 is a cross-sectional schematic diagram showing a display device using a light-emitting element package according to a first embodiment.

FIG. 26 shows an example of a display device 10 in which the light-emitting element package 200 according to the first embodiment described with reference to FIG. 1 is used as a unit pixel.

Referring to FIG. 26, the light-emitting element packages 200 may be arranged at a regular spacing on a wiring substrate 100 including a substrate 110 on which a wiring electrode 120 is formed to constitute the display device 10.

In this regard, as described above, in the light-emitting element package 200, the light-emitting layer 230 and the driving layer 220 may be arranged in the vertical direction so as to at least partially overlap each other.

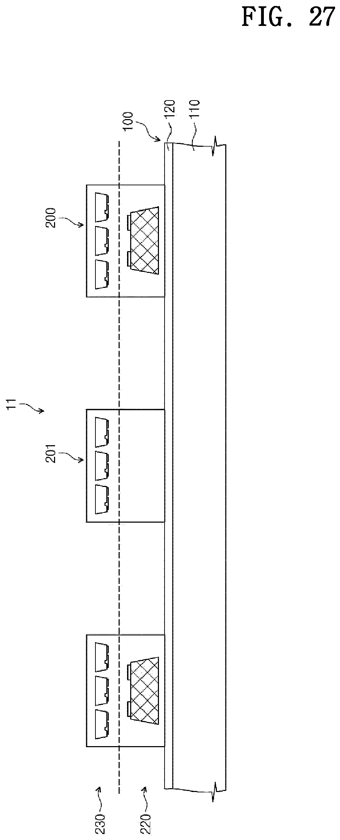

FIG. 27 is a cross-sectional schematic diagram showing a display device using a light-emitting element package according to a second embodiment.

FIG. 27 shows an example of a display device 11 in which the light-emitting element package 200 according to the first embodiment described with reference to FIG. 1 is used as the unit pixel.

According to the present embodiment, one driving chip 250 may drive multiple pixels. Therefore, a light-emitting element package 201 without the driving chip 250 may be used as the pixel. In other words, the light-emitting element package 201 that does not have the driving layer 220 and has only the light-emitting layer 230 may be used as the pixel of the display device 11.

Referring to FIG. 27, the light-emitting element package 200 including the light-emitting layer 220 and the driving layer 220 and the light-emitting element package 201 including the light-emitting layer 230 may be arranged at a regular spacing on the wiring substrate 100 including the substrate 110 on which the wiring electrode 120 is formed to constitute the display device 11.

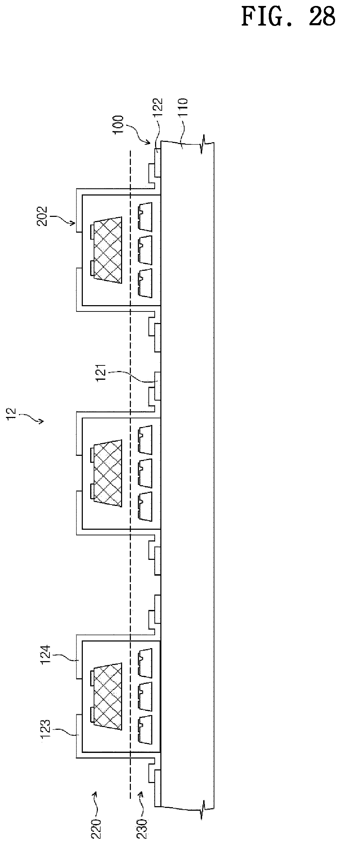

FIG. 28 is a cross-sectional schematic diagram showing a display device using a light-emitting element package according to a third embodiment.

FIG. 28 shows an example of a display device 12 in which the light-emitting element package 202 according to the second embodiment described with reference to FIG. 2 is used as the unit pixel.

Referring to FIG. 28, the light-emitting element packages 202 may be arranged at a regular spacing on the wiring substrate 100 including the substrate 110 on which wiring electrodes 121 and 122 are formed to constitute the display device 12.

For example, the wiring electrodes 121 and 122 and the terminals 211 to 214 of the light-emitting element package 202 may be electrically connected to each other by a first wiring 123 and a second wiring 124.

In this regard, as described above, in the light-emitting element package 200, the light-emitting layer 230 and the driving layer 220 may be arranged in the vertical direction so as to at least partially overlap each other.

The above description is merely illustrative of the technical idea of the present disclosure. Those of ordinary skill in the art to which the present disclosure pertains will be able to make various modifications and variations without departing from the essential characteristics of the present disclosure.

Therefore, embodiments disclosed in the present disclosure are not intended to limit the technical idea of the present disclosure, but to describe, and the scope of the technical idea of the present disclosure is not limited by such embodiments.

The scope of protection of the present disclosure should be interpreted by the claims below, and all technical ideas within the scope equivalent thereto should be construed as being included in the scope of the present disclosure.

## Claims

1. A light-emitting element package comprising:
a first layer including a terminal;
a second layer (a driving layer) located adjacent to the first layer and including a driving chip;
a third layer (a light-emitting layer) located adjacent to the second layer, wherein the third layer includes light-emitting elements, wherein each light-emitting element at least partially overlaps the driving chip in a connection direction of the first layer and the second layer and constitutes a unit subpixel; and
a fourth layer located adjacent to the third layer, wherein light emitted from the light-emitting elements passes through the fourth layer,
wherein a first electrode of each of the light-emitting elements is connected to a first end of the driving chip and a second end of the driving chip is connected to the terminal.

2. The light-emitting element package of claim 1, wherein the first electrode of the light-emitting element is electrically connected to the first end of the driving chip by a first connection electrode located on a first boundary surface between the second layer and the third layer.

3. The light-emitting element package of claim 2, wherein the first boundary surface further includes a second connection electrode connected to a second electrode of the light-emitting element and a power terminal, and a third connection electrode connected to the second end of the driving chip.

4. The light-emitting element package of claim 3, wherein the first boundary surface further includes a fourth connection electrode connected to the driving chip and the terminal.

5. The light-emitting element package of claim 4, wherein the fourth connection electrode includes a through-electrode extending through the second layer.

6. The light-emitting element package of claim 2, wherein the first electrode and a second electrode of the light-emitting element are electrically connected to the first connection electrode and a second connection electrode, respectively, by conductive particles.

7. The light-emitting element package of claim 2, wherein the first electrode and a second electrode of the light-emitting element and the first end and the second end of the driving chip are arranged to face the first boundary surface.

8. The light-emitting element package of claim 1, wherein the first electrode of the light-emitting element is electrically connected to the first end of the driving chip by a fifth connection electrode located on a first boundary surface between the second layer and the third layer and a sixth connection electrode located on a second boundary surface between the first layer and the second layer.

9. The light-emitting element package of claim 8, wherein the fifth connection electrode and the sixth connection electrode are connected to each other by a through-electrode extending through the second layer.

10. The light-emitting element package of claim 9, wherein the first boundary surface further includes a seventh connection electrode connected to a second electrode of the light-emitting element and a power terminal.

11. The light-emitting element package of claim 10, wherein the second boundary surface further includes an eighth connection electrode and a ninth connection electrode connected to the second end of the driving chip.

12. The light-emitting element package of claim 8, wherein the first end and the second end of the driving chip are in contact with the second boundary surface.

13. The light-emitting element package of claim 8, wherein the first electrode and a second electrode of the light-emitting element and the first end and the second end of the driving chip are arranged to face the second boundary surface.

14. The light-emitting element package of claim 1, wherein at least one of the first to fourth layers contains light-scattering particles.

15. The light-emitting element package of claim 14, wherein the light-scattering particles are dispersed in a resin layer.
